# EUROPEAN PATENT APPLICATION

(11) **EP 4 101 905 A1**
(43) Date of publication of application: **14.12.2022**
(21) Application number: 20917379.8
(22) Date of filing: 10.12.2020
(51) Int. Cl.: C09J 9/02, C09J 11/04, C09J 183/05, C09J 183/07, C09J 7/20, C09J 7/38

(54) **ADDITION-CURING SILICONE PRESSURE-SENSITIVE ADHESIVE COMPOSITION AND CURED OBJECT OBTAINED THEREFROM**

(30) Priority: 03.02.2020 JP 2020016200
(71) Applicant: Shin-Etsu Chemical Co., Ltd., Tokyo 100-0005 (JP)
(72) Inventor: OTAKE, Kohei, Annaka-shi, Gunma 379-0224 (JP); KITAGAWA, Taichi, Annaka-shi, Gunma 379-0224 (JP); MATSUMOTO, Nobuaki, Annaka-shi, Gunma 379-0224 (JP); OZAI, Toshiyuki, Annaka-shi, Gunma 379-0224 (JP)
(74) Representative: Mewburn Ellis LLP
(86) International application number: PCT/JP2020/046035
(87) International publication number: WO 2021/157191

(57) **Abstract**

An addition-curing silicone pressure-sensitive adhesive composition which contains no noncrosslinking organopolysiloxane resin and comprises
100 parts by mass of (A) an organopolysiloxane having, in the molecule, at least two alkenyl groups which combine with silicon atoms and having a 25°C viscosity of 0.01-1,000 Pa·s,
5-500 parts by mass of (B) an organopolysiloxane resin having an alkenyl group,
(C) an organohydrogenpolysiloxane having, in the molecule, two or more silicon-atom-bonded hydrogen atoms, the amount of (C) being such that the amount of the silicon-atom-bonded hydrogen atoms contained in the (C) component is 0.1-5.0 times by mole the total amount of all the silicon-atom-bonded alkenyl groups contained in the composition, and
(D) a catalyst based on a platinum-group metal.
The addition-curing silicone pressure-sensitive adhesive composition has excellent tackiness as a temporary fixer and gives cured objects with very little component migration.

## Description

### TECHNICAL FIELD

This invention relates to an addition curable silicone pressure-sensitive adhesive (PSA) composition and a cured product thereof. More particularly, it relates to an addition curable silicone PSA composition and a cured product thereof which can be used as a temporary adhesive for transferring micro-objects.

### BACKGROUND ART

Recently, electronic instruments, typically smartphones, displays and automobile parts face demands not only for higher performance, but also for more space and energy savings. To meet such societal demands, electrical and electronic parts mounted thereon are made smaller and finer. Their assembly process thus becomes more complicated and difficult year by year.

Typical of further miniaturized semiconductor devices are micro-LEDs.

Since micro-LEDs are of fine size from several microns to several tens of microns, bonders for general LEDs are difficult to transfer the micro-LEDs. Then PSA articles obtained by molding and curing silicone PSA compositions on substrates are often utilized as the temporary adhesive for transferring micro-LEDs.

Silicone elastomers are known as the PSA material for this application. Many heat-cure type silicone base PSAs are proposed in Patent Documents 1 to 3.

Since these PSAs are developed mainly for PSA tape, a solid resin component which does not participate in crosslinking is contained as a tackifier. The non-crosslinked resin component causes glue transfer. There is the risk that the material is left on chips when used as micro transfer printing material.

In addition, these materials are insufficient in strength and can undergo cohesive failure during molding or part transfer.

Desired is an addition curable PSA silicone material which is free of a solid resin component not participating in crosslinking and has sufficient bonding force and strength.

### PRIOR ART DOCUMENTS

### PATENT DOCUMENTS

Patent Document 1: JP 5825738
Patent Document 2: JP 2631098
Patent Document 3: JP 5234064

### SUMMARY OF INVENTION

### TECHNICAL PROBLEM

An object of the invention, which has been made under the above-mentioned circumstances, is to provide an addition curable silicone PSA composition which cures into a product having excellent pressure-sensitive adhesion as a temporary adhesive and minimal migration of components, and a cured product thereof.

### SOLUTION TO PROBLEM

Making extensive investigations to attain the above object, the inventors have found that using a vinyl-containing organopolysiloxane, an organohydrogenpolysiloxane, and a vinyl-containing polysiloxane resin, an addition curable silicone PSA composition which cures into a product having excellent pressure-sensitive adhesion is obtained although the composition does not contain a non-crosslinkable resin component like MQ resin (i.e., polysiloxane consisting of M and Q units). The invention is predicated on this finding.

The invention provides the following.
1. An addition curable silicone pressure-sensitive adhesive composition comprising:
   (A) 100 parts by weight of an organopolysiloxane containing at least two silicon-bonded alkenyl groups per molecule and having a viscosity at 25°C of 0.01 to 1,000 Pa·s,
   (B) 5 to 500 parts by weight of an organopolysiloxane resin having an alkenyl group,
   (C) an organohydrogenpolysiloxane having at least two silicon-bonded hydrogen atoms per molecule, in such an amount as to give 0.1 to 5.0 moles of silicon-bonded hydrogen in component (C) per mole of total silicon-bonded alkenyl groups in the composition, and
   (D) a platinum group metal based catalyst,
   the composition being free of a non-crosslinkable organopolysiloxane resin.
2. The composition of 1, further comprising (E) an organic solvent in an amount of 1 to 10,000 parts by weight per 100 parts by weight of component (A).
3. The composition of 1 or 2, further comprising (F) an antistatic agent in an amount of 0.001 to 10 parts by weight per 100 parts by weight of component (A).
4. The composition of any one of 1 to 3, further comprising (G) a reaction inhibitor in an amount of 0.01 to 5.0 parts by weight per 100 parts by weight of component (A).
5. A silicone cured product obtained by curing the addition curable silicone pressure-sensitive adhesive composition of any one of 1 to 4.
6. The cured product of 5, having a bonding force of at least 0.001 MPa.
7. The cured product of 5 or 6, having a tensile strength of at least 0.3 MPa.
8. A pressure-sensitive adhesive comprising the silicone cured product of any one of 5 to 7.
9. A pressure-sensitive adhesive sheet comprising the silicone cured product of any one of 5 to 7.
10. A microstructure transfer stamp comprising the silicone cured product of any one of 5 to 7.
11. The microstructure transfer stamp of 10, having at least one protrusion.
12. A microstructure transfer apparatus comprising the microstructure transfer stamp of 10 or 11.
13. A microstructure holding substrate comprising a pressure-sensitive adhesive layer of the silicone cured product of any one of 5 to 7.
14. A microstructure transfer apparatus comprising the microstructure holding substrate of 13.

### ADVANTAGEOUS EFFECTS OF INVENTION

A cured product of the addition curable silicone PSA composition has appropriate pressure-sensitive adhesion as a temporary adhesive and minimal migration of components upon release.

### BRIEF DESCRIPTION OF DRAWINGS

[FIG. 1] FIG. 1 is a schematic view for illustrating a microstructure transfer stamp in one embodiment of the invention.
[FIG. 2] FIG. 2 is a schematic view for illustrating a microstructure transfer stamp in another embodiment of the invention.
[FIG. 3] FIG. 3 is a schematic view for illustrating one exemplary method of manufacturing the microstructure transfer stamp of the invention.

### DESCRIPTION OF EMBODIMENTS

Now the invention is described in detail.

The invention provides an addition curable silicone PSA composition comprising
(A) an organopolysiloxane containing at least two silicon-bonded alkenyl groups per molecule and having a viscosity at 25°C of 0.01 to 1,000 Pa·s,
(B) an organopolysiloxane resin having an alkenyl group,
(C) an organohydrogenpolysiloxane having at least two silicon-bonded hydrogen atoms per molecule, and
(D) a platinum group metal based catalyst.

### (A) Organopolysiloxane

Component (A) is a crosslinking component in the composition. It is an organopolysiloxane containing at least two silicon-bonded alkenyl groups per molecule and having a viscosity at 25°C of 0.01 to 1,000 Pa·s, preferably 0.05 to 500 Pa·s. If the viscosity at 25°C is less than 0.01 Pa·s, the cured product has a weak bonding force. If the viscosity at 25°C exceeds 1,000 Pa·s, the composition is aggravated in working. As used herein, the viscosity is measured by a rotational viscometer (the same holds true, hereinafter).

The organopolysiloxane is not particularly limited as long as it has a viscosity and alkenyl content in the above ranges. Any well-known organopolysiloxanes may be used. The structure may be either linear or branched. A mixture of two or more organopolysiloxanes having different viscosity is acceptable.

The silicon-bonded alkenyl group is preferably of 2 to 10 carbon atoms, more preferably 2 to 8 carbon atoms, though not limited thereto.

Exemplary of the alkenyl group are vinyl, allyl, 1-butenyl and 1-hexenyl. Inter alia, vinyl is most preferred in view of ease of synthesis and cost.

The alkenyl groups may be attached at ends or midway positions of the organopolysiloxane molecular chain, preferably only at both ends as viewed from flexibility.

Silicon-bonded organic groups other than the alkenyl groups are preferably C₁-C₂₀, more preferably C₁-C₁₀ monovalent hydrocarbon groups, though not limited thereto.

Suitable hydrocarbon groups include alkyl groups such as methyl, ethyl, n-propyl, n-butyl, n-hexyl, and n-dodecyl, aryl groups such as phenyl, and aralkyl groups such as 2-phenylethyl and 2-phenylpropyl.

In these hydrocarbon groups, some or all hydrogen atoms may be substituted by halogen atoms such as chlorine, fluorine and bromine. Examples include halo-substituted monovalent hydrocarbon groups such as fluoromethyl, bromoethyl, chloromethyl, and 3,3,3 -trifluoropropyl.

It is preferred for ease of synthesis and cost that at least 90 mol% of organic groups be methyl.

Therefore, component (A) is most preferably dimethylpolysiloxane blocked with dimethylvinylsilyl at both ends. Component (A) may be used alone or in admixture of two or more.

Specific examples of component (A) include organopolysiloxanes of the following formulae, but are not limited thereto.

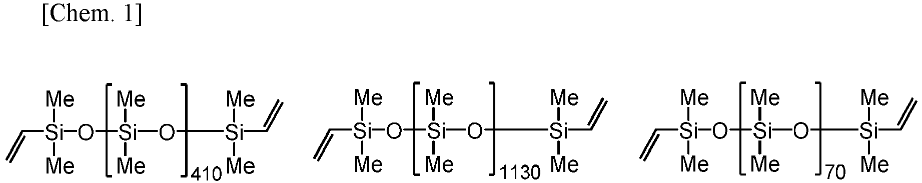

Herein Me stands for methyl. The same holds true, hereinafter.

### (B) Organopolysiloxane resin

Component (B) is a crosslinking resin having an alkenyl group, which plays the role of increasing the hardness and strength of a cured product and letting the cured product develop pressure-sensitive adhesion.

In conventional silicone PSAs, a non-crosslinkable resin is blended to impart pressure-sensitive adhesion. When such PSA is used as a temporary adhesive to chips or the like, the non-crosslinkable resin which is not taken in the crosslinking structure will migrate onto the chips.

By contrast, component (B) used herein has an alkenyl group and is taken in the crosslinking structure upon cure. Thus, on use of the cured product as a temporary adhesive, the migration of components to chips is minimized.

Component (B) preferably has a weight average molecular weight (Mw) of 500 to 30,000, more preferably 1,000 to 20,000. A Mw in the range provides the composition with working efficiency and the cured product with an appropriate bonding force. Notably, Mw is measured by gel permeation chromatography (GPC) versus polystyrene standards.

In component (B), the content of silicon-bonded alkenyl groups is preferably 0.001 to 1.000 mole, more preferably 0.010 to 0.500 mole per 100 g of component (B). An alkenyl content in the range provides the cured product with a satisfactory bonding force and mechanical properties.

Preferably component (B) contains branching units of at least one type selected from trifunctional siloxane units (i.e., organosilsesquioxane units) of the formula: RSiO_{3/2} wherein R is a substituted or unsubstituted monovalent hydrocarbon group and tetrafunctional siloxane units of the formula: SiO_{4/2}.

The organopolysiloxane resin as component (B) may optionally contain monofunctional siloxane units (i.e., triorganosiloxy units) and/or difunctional siloxane units (i.e., diorganosiloxane units). The total content of RSiO_{3/2} units and SiO_{4/2} units is preferably at least 10 mol%, more preferably 20 to 90 mol% of the overall siloxane units in the organopolysiloxane resin as component (B).

In the RSiO_{3/2} units, R is a substituted or unsubstituted monovalent hydrocarbon group, preferably of 1 to 10 carbon atoms. Examples include alkyl groups such as methyl, ethyl, n-propyl, isopropyl, n-butyl, isobutyl, tert-butyl, n-pentyl, neopentyl, n-hexyl, n-heptyl, n-octyl, n-nonyl, and n-decyl, cycloalkyl groups such as cyclopentyl, cyclohexyl and cycloheptyl, alkenyl groups (inclusive of cycloalkenyl groups, herein) such as vinyl, allyl (or 2-propenyl), 1-propenyl, isopropenyl, butenyl, pentenyl, hexenyl, and cyclohexenyl, aryl groups such as phenyl, tolyl, xylyl, naphthyl and biphenylyl, aralkyl groups such as benzyl, phenylethyl, and phenylpropyl, and alkaryl groups such as methylbenzyl.

In these hydrocarbon groups, one or more hydrogen atoms may be substituted by halogen atoms such as fluorine, chlorine and bromine, or cyano. Suitable substituted hydrocarbon groups include halogenated alkyl groups such as chloromethyl, 2-bromoethyl, 3-chloropropyl, and 3,3,3-trifluoropropyl.

Examples of component (B) include copolymers consisting of R¹₃SiO_{1/2} units, R¹R²SiO_{2/2} units and SiO_{4/2} units; copolymers consisting of R¹₃SiO_{1/2} units, R¹₂SiO_{2/2} units, R¹R²SiO_{2/2} units, and SiO_{4/2} units; copolymers consisting of R¹₃SiO_{1/2} units, R¹₂R²SiO_{1/2} units, R¹₂SiO_{2/2} units and SiO_{4/2} units; copolymers consisting of R¹₃SiO_{1/2} units, R¹₂R²SiO_{1/2} units, and SiO_{4/2} units; copolymers consisting of R¹₂R²SiO_{1/2} units, R¹₂SiO_{2/2} units and SiO_{4/2} units; and copolymers consisting of R¹R²SiO_{2/2} units and R¹SiO_{3/2} units and/or R²SiO_{3/2} units.

In the above formulae, R¹ is a substituted or unsubstituted monovalent hydrocarbon group free of aliphatic unsaturation. Of the monovalent hydrocarbon groups exemplified above for R, those groups exclusive of alkenyl groups are exemplary. Preferred examples include alkyl groups such as methyl, ethyl, n-propyl, n-butyl, n-pentyl, n-hexyl, and n-heptyl, aryl groups such as phenyl, tolyl, xylyl and naphthyl, aralkyl groups such as benzyl and phenethyl, and halogenated alkyl groups such as chloromethyl, 3-chloropropyl, and 3,3,3-trifluoropropyl.

R² is an alkenyl group such as vinyl, allyl, butenyl, pentenyl, hexenyl or heptenyl.

Illustrative examples of component (B) include copolymers consisting of (CH₃)₃SiO_{1/2} units, (CH₂=CH)SiO_{3/2} units and SiO_{4/2} units; copolymers consisting of (CH₂=CH)(CH₃)₂SiO_{1/2} units and SiO_{4/2} units; copolymers consisting of (CH₂=CH)(CH₃)₂SiO_{1/2} units, (CH₂=CH)SiO_{3/2} units and SiO_{4/2} units; copolymers consisting of (CH₃)₃SiO_{1/2} units, (CH₂=CH)(CH₃)₂SiO_{1/2} units and SiO_{4/2} units; and the foregoing copolymers in which some methyl is substituted by phenyl.

Specific examples of component (B) include copolymers of the following average unit formulae. Herein, Vi stands for vinyl (the same holds true, hereinafter).
(Me₃SiO_{1/2})_{0.35}(ViMe₂SiO_{1/2})_{0.1}(SiO_{4/2})_{0.55}
(Me₃SiO_{1/2})_{0.4}(ViMe₂SiO_{1/2})_{0.1}(SiO_{4/2})_{0.5}
(ViMeSiO)_{0.4}(Me₂SiO)_{0.15}(MeSiO_{3/2})_{0.45}
(ViMe₂SiO_{1/2})_{0.2}(Me₂SiO)_{0.25}(MeSiO_{3/2})_{0.55}
(Me₃SiO_{1/2})_{0.2}(ViMe₂SiO_{1/2})_{0.05}(MeSiO_{3/2})_{0.75}

Component (B) is blended in an amount of 5 to 500 parts by weight, preferably 10 to 400 parts by weight per 100 parts by weight of component (A). If the amount of component (B) is less than 5 parts by weight, the composition fails to develop a satisfactory bonding force as temporary adhesive. If the amount of component (B) exceeds 500 parts by weight, no pressure-sensitive adhesion is available.

Component (B) may be used alone or in admixture.

### (C) Organohydrogenpolysiloxane

Component (C) is an organohydrogenpolysiloxane having at least two (typically 2 to 300), preferably at least 3 (typically 3 to 150) silicon-bonded hydrogen atoms or SiH groups per molecule. It may be a linear, branched, or cyclic polysiloxane or a resinous polysiloxane of three-dimensional network structure.

The number of silicon atoms per molecule, i.e., degree of polymerization of the organohydrogenpolysiloxane is typically 2 to about 300, preferably 3 to about 200.

One typical example is an organohydrogenpolysiloxane having the average compositional formula (1).

HₐR³_{b}SiO_{(4-a-b)/2} (1)

Herein R³ is each independently a substituted or unsubstituted monovalent hydrocarbon group free of aliphatic unsaturation, a and b are numbers in the range: 0 < a < 2, 0.8 ≤ b ≤ 2 and 0.8 < a+b ≤ 3, preferably 0.05 ≤ a ≤ 1, 1.5 ≤ b ≤ 2 and 1.8 ≤ a+b ≤ 2.7.

R³ is a monovalent hydrocarbon group free of aliphatic unsaturation, preferably of 1 to 10 carbon atoms. Examples include alkyl groups such as methyl, ethyl, n-propyl, isopropyl, n-butyl, isobutyl, tert-butyl, n-pentyl, neopentyl, n-hexyl, n-heptyl, n-octyl, n-nonyl, and n-decyl, cycloalkyl groups such as cyclopentyl, cyclohexyl and cycloheptyl, aryl groups such as phenyl, tolyl, xylyl, naphthyl and biphenylyl, aralkyl groups such as benzyl, phenylethyl, and phenylpropyl, alkaryl groups such as methylbenzyl, and substituted forms of the foregoing hydrocarbon groups in which one or more hydrogen atoms are substituted by halogen atoms such as fluorine, chlorine and bromine, or cyano, typically halogenated alkyl groups such as chloromethyl, 2-bromoethyl, 3-chloropropyl, and 3,3,3-trifluoropropyl.

Of these, groups of 1 to 7 carbon atoms are preferred, with C₁-C₃ alkyl groups such as methyl, phenyl and 3,3,3-trifluoropropyl being more preferred.

Examples of the organohydrogenpolysiloxane include siloxane oligomers such as 1,1,3,3-tetramethyldisiloxane, 1,3,5,7-tetramethylcyclotetrasiloxane, 1,3,5,7,8-pentamethylcyclopentasiloxane, tris(dimethylhydrogensiloxy)methylsilane, and tris(dimethylhydrogensiloxy)phenylsilane; methylhydrogencyclopolysiloxane, methylhydrogensiloxane/dimethylsiloxane cyclic copolymers, molecular both end trimethylsiloxy-blocked methylhydrogenpolysiloxane, molecular both end trimethylsiloxy-blocked dimethylsiloxane/methylhydrogensiloxane copolymers, molecular both end dimethylhydrogensiloxy-blocked dimethylpolysiloxane, molecular both end dimethylhydrogensiloxy-blocked methylhydrogenpolysiloxane, molecular both end dimethylhydrogensiloxy-blocked dimethylsiloxane/methylhydrogensiloxane copolymers, silicone resins comprising R³₂(H)SiO_{1/2} units and SiO_{4/2} units, and optionally R³₃SiO_{1/2} units, R³₂SiO_{2/2} units, R³(H)SiO_{2/2} units, (H)SiO_{3/2} units or R³SiO_{3/2} units wherein R³ is as defined above, and substituted forms of the foregoing in which some methyl groups are substituted by other alkyl groups such as ethyl and n-propyl and/or phenyl groups.

The organohydrogenpolysiloxane used herein may be obtained by any well-known methods, for example, by (co)hydrolysis of at least one chlorosilane selected from R³SiHCl₂ and R³₂SiHCl wherein R³ is as defined above, or cohydrolysis of said chlorosilane and at least one chlorosilane selected from R³₃SiCl and R³₂SiCl₂ wherein R³ is as defined above. The organohydrogenpolysiloxane used herein may be a product obtained by further subjecting the polysiloxane resulting from such cohydrolysis to equilibration reaction.

The organohydrogenpolysiloxane as component (C) is used in such an amount as to give 0.1 to 5.0 silicon-bonded hydrogen atoms (i.e., SiH groups), preferably 0.2 to 2.0 SiH groups in component (C) per silicon-bonded alkenyl group in total in the organopolysiloxanes as components (A) and (B).

Component (C) may be used alone or in admixture.

### (D) Platinum group metal based catalyst

Component (D) is a platinum group metal based catalyst for promoting addition reaction of alkenyl groups in components (A) and (B) with SiH groups in component (C). It may be any of well-known catalysts, preferably platinum and platinum compounds.

Examples of the catalyst include platinum group metals alone such as platinum (including platinum black), rhodium and palladium; platinum chlorides, chloroplatinic acids and chloroplatinates such as H₂PtCl₄·nH₂O, H₂PtCl₆·nH₂O, NaHPtCl₆·nH₂O, KHPtCl₆·nH₂O, Na₂PtCl₆·nH₂O, K₂PtCl₄·nH₂O, PtCl₄·nH₂O, PtCl₂ and Na₂HPtCl₄·nH₂O, wherein n is an integer of 0 to 6, preferably 0 or 6; alcohol-modified chloroplatinic acids; chloroplatinic acid-olefin complexes; supported catalysts comprising platinum group metals such as platinum black and palladium on supports of alumina, silica and carbon; rhodium-olefin complexes; chlorotris(triphenylphosphine)rhodium (known as Wilkinson's catalyst); and complexes of platinum chlorides, chloroplatinic acids and chloroplatinates with vinyl-containing siloxanes. These compounds may be used alone or in admixture.

Component (D) is used in a catalytic amount. The amount is sufficient for the reaction of components (A) and (B) with component (C) to take place, and may be adjusted as appropriate depending on the desired cure rate.

Specifically, the amount is 0.1 to 10,000 ppm, more specifically 1 to 5,000 ppm of platinum group metal based on the weight of component (A). When the amount of component (D) is within the range, efficient catalysis is expectable.

### (E) Organic solvent

Although the silicone composition of the invention may be a solventless composition obtained by blending predetermined amounts of components (A) to (D), it may also be used as a solution type composition by diluting it with an organic solvent. As a result of dilution with an organic solvent, many practical advantages are obtained with respect to coating operation, coating efficiency and film thickness control in the case of a spin coater, the states of coated film such as thickness and surface finish.

Any organic solvents may be used as long as silicone is dissolvable therein. Suitable organic solvents include aromatic hydrocarbon compounds such as toluene and xylene, aliphatic hydrocarbon compounds such as hexane, heptane and isoparaffin, ketone compounds such as acetone, methyl ethyl ketone, and methyl isobutyl ketone, esters such as ethyl acetate and butyl acetate, and ethers such as diisopropyl ether and 1,4-dioxane, which may be used alone or in admixture.

The amount of organic solvent, if used, is preferably 1 to 10,000 parts by weight, more preferably 10 to 5,000 parts by weight per 100 parts by weight of component (A). No effective dilution is achievable with less than 1 part by weight of the solvent. If the amount of the solvent exceeds 10,000 parts by weight, the resulting coating may be too thin.

### (F) Antistatic agent

An antistatic agent may be added to the inventive composition as component (F) for the purposes of reducing surface resistivity and imparting antistatic properties to the composition.

Suitable antistatic agents include salts of alkali and alkaline earth metals, and ionic liquids. As used herein, the ionic liquids refer to fused salts which are liquid at room temperature (25°C), that is, normally fused salts, and specifically fused salts having a melting point of up to 50°C, preferably -100°C to 30°C, and more preferably -50°C to 20°C. These ionic liquids are characterized by having no vapor pressure (non-volatile) and by high heat resistance, incombustibility, and chemical stability.

Specifically the salts of alkali and alkaline earth metals are salts of alkali metals such as lithium, sodium and potassium, and salts of alkaline earth metals such as calcium and barium. Exemplary alkali metal salts include LiClO₄, LiCF₃SO₃, LiN(CF₃SO₂)₂, LiAsF₆, LiCl, NaSCN, KSCN, NaCl, NaI, and KI. Exemplary alkaline earth metal salts include Ca(ClO₄)₂ and Ba(ClO₄)₂.

Of these, lithium salts such as LiClO₄, LiCF₃SO₃, LiN(CF₃SO₂)₂, LiAsF₆, and LiCl are preferred in view of resistivity and solubility, with LiCF₃SO₃ and LiN(CF₃SO₂)₂ being more preferred.

The preferred ionic liquid consists of a quaternary ammonium cation and an anion. The quaternary ammonium cation is imidazolium, pyridinium or a cation R⁶₄N⁺ [wherein R⁶ is each independently hydrogen or a C₁-C₂₀ organic group.]

The organic groups represented by R⁶ include C₁-C₂₀ monovalent hydrocarbon groups and alkoxyalkyl groups, for example. Illustrative examples include alkyl groups such as methyl, pentyl, hexyl and heptyl; aryl groups such as phenyl, tolyl, xylyl and naphthyl; aralkyl groups such as benzyl and phenethyl; cycloalkyl groups such as cyclopentyl, cyclohexyl and cyclooctyl; and alkoxyalkyl groups such as ethoxyethyl (-CH₂CH₂OCH₂CH₃). Two of the organic groups represented by R⁶ may bond together to form a cyclic structure, and in this case, two R⁶ taken together form a divalent organic group. The main chain of this divalent organic group may consist of carbon atoms or may further contain a heteroatom or atoms such as oxygen and nitrogen atoms. Typical divalent organic groups are divalent hydrocarbon groups, for example, C₃-C₁₀ alkylene groups and groups of the formula: -(CH₂)_{c}-O-(CH₂)_{d}- wherein c is an integer of 1 to 5, d is an integer of 1 to 5, and c+d is an integer of 4 to 10.

Examples of the cation R⁶₄N⁺ include methyltri-n-octylammonium cation, ethoxyethylmethylpyrrolidinium cation and ethoxyethylmethylmorpholinium cation.

Although the anion used herein is not critical, preferred anions include AlCl₄⁻, Al₃Cl₁₀⁻, Al₂Cl₇⁻, ClO₄⁻, PF₆⁻, BF₄⁻, CF₃SO₃⁻, (CF₃SO₂)₂N⁻, and (CF₃SO₂)₃C⁻, with PF₆⁻, BF₄⁻, CF₃SO₃⁻, and (CF₃SO₂)₂N⁻ being more preferred.

The amount of component (F), if used, is preferably 0.001 to 10 parts by weight, more preferably 0.005 to 10 parts by weight per 100 parts by weight of component (A), as viewed from antistatic effect and heat resistance.

The antistatic agent may be used alone or in admixture.

In the embodiment wherein the silicone PSA composition contains component (F), a cured product of the composition preferably has such an antistatic effect that when a corona discharge is applied to a cured product to establish a static charge of 6 kV on its surface using a Static Honestmeter (Shishido Electrostatic, Ltd.), the time until the charged voltage decreases to one-half (i.e., half life) is within 2 minutes, more preferably within 1 minute.

### (G) Reaction inhibitor

A reaction inhibitor may be added to the inventive composition as component (G) for the purposes of suppressing the progress of curing reaction at room temperature for thereby prolonging the shelf life and pot life of the composition.

The reaction inhibitor may be selected from well-known ones as long as it suppresses the catalytic activity of component (D).

Examples of the reaction inhibitor include acetylene alcohol compounds such as 1-ethynyl-1-cyclohexanol and 3-butyn-1-ol, various nitrogen compounds, organic phosphorus compounds, oxime compounds, and organic chlorine compounds, which may be used alone or in admixture. Of these, acetylene alcohol compounds are preferred because they are non-corrosive to metals.

When used, component (G) is blended in an amount of 0.001 to 5 parts by weight, preferably 0.01 to 1 part by weight per 100 parts by weight of component (A). Less than 0.001 part by weight of component (G) may fail to gain a satisfactory shelf or pot life whereas more than 5 parts by weight may render the composition less curable.

The reaction inhibitor may be diluted with an organic solvent such as toluene, xylene or isopropyl alcohol prior to use, in order to facilitate its dispersion in the silicone resin.

Besides the foregoing components, any additives may be added to the composition as long as the objects of the invention are not impaired. Suitable additives include, for example, colorants (e.g., pigments and dyes), silane coupling agents, adhesion promoters, polymerization inhibitors, antioxidants, UV absorbers (or light resistant stabilizers) and photo-stabilizers.

Prior to use, the inventive composition may also be blended with another resin composition.

The addition curable silicone PSA composition of the invention may be prepared by mixing components (A) to (D) and optional components in any desired order and agitating them. The steps of mixing and agitating components are not particularly limited.

The composition may be formulated as either one or two-pack type. The one-pack composition may be long stored in refrigerators or freezers. The two-pack composition may be long stored at room temperature.

Specifically, a one-pack type composition comprising components (A) to (G) may be prepared by charging a gate mixer (for example, planetary mixer by Inoue Mfg. Inc.) with components (A), (B), (D), (E) and (F), mixing the contents at room temperature for 30 minutes, then adding component (G), mixing at room temperature for 30 minutes, then adding component (C), and mixing at room temperature for 30 minutes.

Alternatively, the composition may be formulated as a two-pack type composition in any combination of the components as long as components (A), (C), and (D) or components (B), (C) and (D) do not coexist at the same time. For example, a two-pack type composition consisting of agents A and B may be prepared as follows. A gate mixer is charged with components (A), (B), (D), (E) and (F), which are mixed at room temperature for 30 minutes, yielding agent A. Separately, a gate mixer is charged with components (A), (C) and (G), which are mixed at room temperature for 30 minutes, yielding agent B.

From the aspects of shapability and workability during coating, the silicone PSA composition preferably has a viscosity at 23°C of up to 1,000 Pa·s, more preferably up to 500 Pa·s, even more preferably up to 100 Pa·s, as measured by a rotational viscometer. A viscosity in excess of 5,000 Pa·s may be detrimental to workability.

The curing conditions for the addition curable silicone PSA composition are not particularly limited and may be similar to conditions used for well-known curable silicone compositions. Either room temperature curing or heat curing may be utilized. The composition may be cured through addition reaction at a temperature of preferably 20 to 180°C, more preferably 50 to 150°C for a time of preferably 0.1 to 3 hours, more preferably 0.5 to 2 hours.

The cured product preferably has a bonding force of at least 0.001 MPa, more preferably at least 0.005 MPa in consideration of a balance between adhesion (or bonding) and release (or separation) of the object to be transferred. The upper limit of bonding force is preferably 1.0 MPa, more preferably 0.5 MPa in consideration of a balance between adhesion and release of the object.

Since the composition does not contain a non-crosslinkable organopolysiloxane resin, the bonding force of the cured product largely depends on the amount of component (B) as mentioned above.

When it is considered that the cured product of the addition curable silicone PSA composition undergoes no cohesive failure during molding thereof or transfer of micro-objects such as chips, the cured product should preferably have a tensile strength of at least 0.3 MPa, more preferably at least 0.5 MPa, as measured at thickness 2.0 mm according to JIS K 6249: 2003. The upper limit of tensile strength is typically about 50 MPa, though not critical.

Also, the silicone PSA composition may be used as PSA articles by coating it to various substrates and curing.

The substrate is not particularly limited and plastic films, glass and metals may be used.

Suitable plastic films include polyethylene films, polypropylene films, polyester films, polyimide films, polyvinyl chloride films, polyvinylidene chloride films, polyvinyl alcohol films, polycarbonate films, polystyrene films, ethylene-vinyl acetate copolymer films, ethylene-vinyl alcohol copolymer films, and triacetyl cellulose films.

The glass used herein is not particularly limited with respect to the thickness and type, and even chemically strengthened glass is acceptable.

For improving the adhesion between the substrate and the PSA layer, the substrate may be treated such as by primer treatment or plasma treatment, prior to use.

The coating means or method may be selected as appropriate from well-known coating means or methods such as a spin coater, comma coater, lip coater, roll coater, die coater, knife coater, blade coater, rod coater, kiss coater, gravure coater, screen printing, dipping and casting methods.

Also, a cured product of the silicone PSA composition may be prepared by potting in a mold.

In case bubbles are entrapped in the potting step of pouring the composition into a mold, the bubbles can be removed under reduced pressure. The mold used herein may be, for example, a resist template, that is, a photoresist film (on a silicon wafer) which is engraved with a desired contour (raised and recessed portions).

If it is desired to take out the cured product from the mold, preferably the mold is treated with a parting agent before potting of the composition. For example, fluorine and silicone base parting agents may be used.

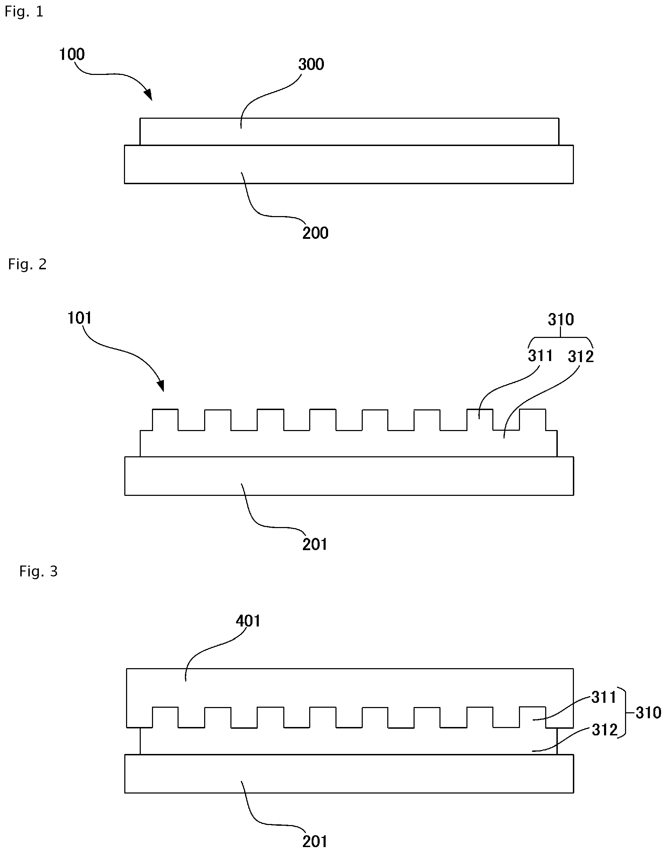

Referring to FIGS. 1 and 2, the cured product of the addition curable silicone PSA composition is used as microstructure transfer stamps 100 and 101 for transferring miniature devices and parts.

In FIG. 1, the microstructure transfer stamp 100 comprises a substrate 200 and a cured product layer 300 of the silicone PSA composition thereon. In this embodiment, the cured composition layer 300 may have any size falling within the extent of the substrate 200, and even exactly the same size as the substrate 200.

The material of the substrate 200 is not particularly limited. Examples include plastic films, glass, synthetic quartz, and metals. Also, the substrate is not particularly limited with respect to the thickness and type, and even chemically strengthened one is acceptable. For improving the adhesion between the substrate and the PSA layer, the substrate may be subjected to primer treatment or plasma treatment, prior to use. For the purpose of preventing misalignment in transferring microstructures and thereby improving the transfer accuracy, synthetic quartz having high flatness is preferably used.

The method of forming the cured product layer 300 on the substrate 200 is not particularly limited. For example, the method may be either a method comprising the steps of directly applying the silicone PSA composition in uncured state onto the substrate 200 and curing the composition or a method comprising the step of bonding a sheet-like cured product of the silicone PSA composition to the substrate 200.

In the method comprising the steps of directly applying the silicone PSA composition onto the substrate 200 and curing the composition, a microstructure transfer stamp 100 may be obtained by coating the silicone PSA composition onto the substrate 200 and then curing the composition.

The coating means or method may be selected as appropriate from well-known coating means or methods such as a spin coater, comma coater, lip coater, roll coater, die coater, knife coater, blade coater, rod coater, kiss coater, gravure coater, screen printing, dipping and casting methods.

After the silicone PSA composition is coated to the substrate by any of these methods, the composition may be cured while carrying out press molding or compression molding. There is obtained a microstructure transfer stamp 100 having high flatness.

In the method comprising the step of bonding the sheet-like cured product of the silicone PSA composition to the substrate 200, a microstructure transfer stamp 100 may be obtained by molding the composition into a sheet and bonding the sheet to the substrate 200.

The method for molding the silicone PSA composition into a sheet may be selected as appropriate from molding methods such as roll forming, press molding, transfer molding, and compression molding. The composition is preferably molded into a sheet-like cured product while sandwiching the composition between plastic films for preventing dust deposition or suppressing oxygen cure inhibition. When the resulting sheet-like cured product is larger than the desired size, it may be cut to the desired size.

In order to increase the adhesion of the sheet-like cured product to the substrate 200, either one or both of the bonding surfaces may be subjected to plasma treatment, excimer laser treatment or chemical treatment. Any adhesives or pressure-sensitive adhesives may be used for enhancing the bonding strength. Examples thereof include silicone base, acrylic base, and epoxy base adhesives.

The bonding method used herein may be, for example, roll bonding or vacuum pressing.

The silicone PSA cured product layer 300 in the microstructure transfer stamp 100 preferably has a thickness of 1 µm to 1 cm, more preferably 10 µm to 5 mm from the aspects of moldability and flatness.

Referring to FIG. 2, the microstructure transfer stamp 101 comprises a substrate 201 and a cured product layer 310 of the silicone PSA composition thereon. The material of substrate 201 is as exemplified above for substrate 200. The silicone PSA cured product layer 310 has protrusions 311 on the surface. A base layer 312 may be formed underneath the protrusions 311.

The method of forming the cured product layer 310 on the substrate 201 is not particularly limited. Examples include a method comprising the step of directly molding the cured product layer 310 on the substrate 201 by in-mold shaping and a method comprising the step of bonding a sheet-like cured product having the protrusions 311 to the substrate 201.

In the method comprising the step of directly molding the silicone PSA cured product layer 310 on the substrate 201 by in-mold shaping, the microstructure transfer stamp 101 may be obtained as shown in FIG. 3 by filling the silicone PSA composition between the substrate 201 and a mold 401, curing the composition, and then removing the mold 401.

The mold 401 used herein may be, for example, a resist template, that is, a photoresist film (on a silicon wafer or quartz substrate) which is engraved with a desired contour (raised and recessed portions) or a resin template, that is, an addition curable resin which is engraved with a desired contour by patternwise exposure. In the case of resin templates, various plastic films may be used as the substrate.

The step of filling the silicone PSA composition between the substrate 201 and the mold 401 may be performed by applying the silicone PSA composition to the substrate 201 and/or the mold 401 and bonding them together. The applying and bonding methods may be as described above. There is a possibility that small bubbles are entrapped in the mold 401 during the applying step. This problem can be solved by vacuum bonding or debubbling under reduced pressure.

After the silicone PSA composition is applied to the substrate by any of these methods, the composition is cured while carrying out press molding, compression molding or roll press molding, thereby forming the microstructure transfer stamp 101.

In an alternative method, a microstructure transfer stamp 101 is obtained by screen printing the silicone PSA composition through a mesh having the desired pattern, and curing the composition. Since the silicone PSA composition is good in shape retention, the desired pattern shape is kept substantially unchanged until curing after coating.

In the method of bonding the sheet-like silicone PSA cured product having protrusions 311 to the substrate 201, the microstructure transfer stamp 101 may be obtained by molding the silicone PSA composition into a sheet-like cured product having protrusions 311 and bonding the sheet to the substrate 201.

The method for molding the silicone PSA composition into a sheet-like cured product having protrusions 311 may be selected as appropriate from molding methods such as roll forming, press molding, transfer molding, and compression molding methods using a mold provided with the same contour as the mold 401.

The composition is preferably molded into a sheet-like cured product while sandwiching the composition between plastic films for preventing dust deposition or suppressing oxygen cure inhibition. When the resulting sheet-like cured product is larger than the desired size, it may be cut to the desired size.

In order to improve the adhesion of the sheet-like cured product to the substrate 201, the bonding surfaces may be subjected to plasma treatment, excimer laser treatment or chemical treatment. Various adhesives and pressure-sensitive adhesives as described above may be used for enhancing the bonding strength.

The bonding method used herein may be, for example, roll bonding or vacuum pressing.

The size and arrangement of the protrusions 311 may be designed depending on the desired size and arrangement of microstructures to be transferred.

The upper surface of the protrusions 311 is flat. The surface shape is not limited and encompasses circular, oval, rectangular and other shapes. In the case of rectangular shape, the edges may be rounded without raising any problems. The upper surface of the protrusions 311 preferably has a width of 0.1 µm to 1 cm, more preferably 1 µm to 1 mm.

The side wall of the protrusions 311 is not limited in morphology and may be either vertical or oblique.

The protrusions 311 preferably have a height of 0.1 µm to 1 cm, more preferably 1 µm to 1 mm.

The pitch distance between spaced-apart adjacent protrusions 311 is preferably 0.1 µm to 10 cm, more preferably 1 µm to 1 mm.

The base layer 312 preferably has a thickness of 0.1 µm to 1 cm, more preferably 1 µm to 5 mm.

The microstructure transfer stamp defined above may be used by mounting it on a setup to construct a microstructure transfer apparatus. Although the means for mounting it on a setup is not particularly limited, for example, vacuum chucks or pressure-sensitive adhesive sheets may be used. The transfer of microstructures with the microstructure transfer apparatus can be achieved by picking up microstructures such as chips due to the bonding force of the microstructure transfer stamp, moving them to the desired place, and releasing them.

One example of transferring microstructures is described below. In a laser lift-off (LLO) process of releasing a sapphire substrate of a semiconductor device from a GaN base compound crystal layer using laser light, the microstructure transfer stamp 100 or 101 may be utilized as a holding substrate (donor substrate) for temporarily fixing a semiconductor device so as to prevent any misalignment of the released semiconductor device. As the substrate 200 or 201 of the stamp 100 or 101, synthetic quartz having high flatness is preferably used.

For selectively picking up semiconductor devices temporarily bonded to the holding substrate, the microstructure transfer stamp 100 or 101 having a greater bonding force than the holding substrate may be used. The thus picked-up semiconductor device is transferred to the desired position on an (acceptor) substrate on which it is to be mounted, the semiconductor device is bonded to the acceptor substrate by soldering, the microstructure transfer stamp is separated from the semiconductor device. In this way, the steps of transferring a semiconductor device and mounting the device onto a substrate are accomplished.

The cured product layer 300 or 310 of the holding substrate preferably has a bonding force of 0.001 to 2 MPa, more preferably 0.002 to 1 MPa in consideration of a balance between adhesion and release of the object to be transferred. The cured product layer 300 or 310 of the microstructure transfer stamp preferably has a greater bonding force than the bonding force of the holding substrate, specifically at least 0.01 MPa, more preferably at least 0.1 MPa.

### EXAMPLES

Examples and Comparative Examples are given below for further illustrating the invention although the invention is not limited thereto.

The compounds used as the relevant components are shown below.

### Component (A)

(A-1) organopolysiloxane of the formula below, having a viscosity of 5 Pa·s at 25°C 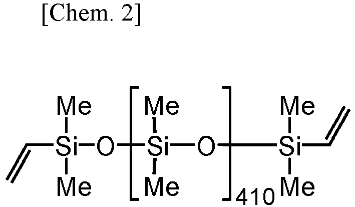
(A-2) organopolysiloxane of the formula below, having a viscosity of 100 Pa·s at 25°C 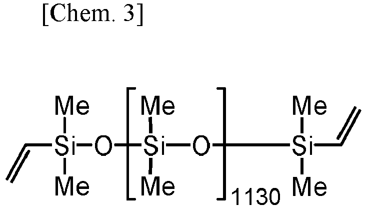
(A-3) organopolysiloxane of the formula below, having a viscosity of 0.1 Pa·s at 25°C

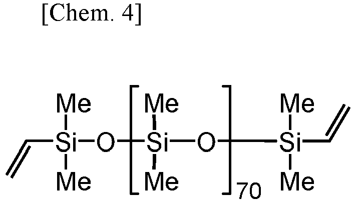

### Component (B)

(B-1) organopolysiloxane resin of Me₃SiO_{1/2} : Me₂ViSiO_{1/2} : SiO_{4/2} = 0.35:0.10:0.55, Mw 5,300, Si-Vi content 0.085 mol/100 g
(B-2) organopolysiloxane resin of Me₃SiO_{1/2} : ViMe₂SiO_{1/2} : MeSiO₃₂ = 0.20:0.05:0.75, Mw 13,000, Si-Vi content 0.059 mol/100 g

### Component (C)

(C-1) organohydrogenpolysiloxane of the formula below

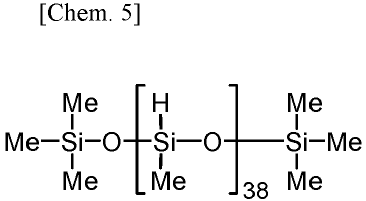

### Component (D)

(D-1) solution of platinum-divinyltetramethyldisiloxane complex in dimethylpolysiloxane capped with dimethylvinylsilyl at both ends and having a viscosity of 0.6 Pa·s at 25°C, containing 1 wt% Pt

### Component (E)

(E-1) xylene

### Component (F)

(F-1) adipate containing 20 wt% of LiN(SO₂CF₃)₂

### Component (G)

(G-1) 1-ethynyl-1-cyclohexanol

### [Examples 1 to 11 and Comparative Examples 1 to 2]

A gate mixer (5-L planetary mixer by Inoue Mfg. Inc.) was charged with amounts (shown in Table 1) of components (A), (B), (D), (E), and (F), which were agitated at room temperature for 30 minutes. Then an amount (shown in Tables 1 and 2) of component (G) was fed to the mixer and agitated at room temperature for 30 minutes. Finally an amount (shown in Table 1) of component (C) was fed to the mixer and agitated at 25°C for 30 minutes until uniform. Each of the resulting compositions was measured for various physical properties by the methods shown below, with the results shown in Tables 1 and 2. Notably, the viscosity of the composition in Tables 1 and 2 is as measured at 23°C by a rotational viscometer.

### [Measurement of physical properties of cured product]

The silicone composition prepared above was cured into a sheet by pressing at 150°C for 10 minutes and heating in an oven at 150°C for 20 minutes. The sheet was 2.0 mm thick. The sheet or cured product was measured for hardness, tensile strength and elongation at break according to JIS K6249: 2003.

The adhesiveness of the cured product was measured by a compact tabletop tester EZ-SX (Shimadzu Corp.). The procedure included pressing a stainless steel (SUS) probe of 1 mm square to the cured product of 1 mm thick under 1 MPa for 15 seconds and then pulling back the probe at a rate of 200 mm/min while measuring the load (bonding force) required for pulling.

The cured product was examined for antistatic effect by using a Static Honestmeter (Shishido Electrostatic, Ltd.), applying a corona discharge to the sheet or cured product of 2 mm thick to establish a static charge of 6 kV on its surface, and measuring the time (half-life) until the charged voltage decreased to one-half.

**[Table 1]**

| | | Example | | | | | |
|---|---|---|---|---|---|---|---|
| | | 1 | 2 | 3 | 4 | 5 | 6 |
| Composition (pbw) | A-1 | 100 | 100 | 100 | 100 | | |
| | A-2 | | | | | 100 | |
| | A-3 | | | | | | 100 |
| | B-1 | 100 | 67 | 33 | 11 | 33 | 100 |
| | B-2 | | | | | | |
| | C-1 | 5.2 | 3.7 | 2.0 | 0.9 | 1.5 | 10.4 |
| | D-1 | 0.30 | 0.20 | 0.16 | 0.13 | 0.16 | 0.30 |
| | E-1 | | | | | | |
| | F-1 | | | | | | |
| | G-1 | 0.10 | 0.13 | 0.11 | 0.09 | 0.11 | 0.10 |
| H/Vi | | 1.0 | 1.0 | 1.0 | 1.0 | 0.8 | 1.2 |
| Physical properties of composition | Viscosity (Pa·s) | 16 | 7 | 5 | 5 | 83 | 1 |
| Physical properties of cured product | Hardness (Type A) | 60 | 38 | 24 | 15 | 14 | 75 |
| | Tensile strength (MPa) | 6.1 | 4.7 | 1.6 | 0.4 | 1.4 | 1.2 |
| | Elongation at break (%) | 250 | 270 | 180 | 200 | 350 | 20 |
| | Bonding force (MPa) | 0.370 | 0.180 | 0.010 | 0.004 | 0.040 | 0.006 |
| | Half-life @6kV | >10 min | >10 min | >10 min | >10 min | >10 min | >10 min |

**[Table 2]**

| | | Example | | | | | Comparative Example | |
|---|---|---|---|---|---|---|---|---|
| | | 7 | 8 | 9 | 10 | 11 | 1 | 2 |
| Composition (pbw) | A-1 | 100 | 100 | | 100 | | 100 | 100 |
| | A-2 | | | 100 | | 100 | | |
| | A-3 | | | | | | | |
| | B-1 | | | 33 | 67 | 33 | | 900 |
| | B-2 | 400 | 67 | | | | | |
| | C-1 | 14.5 | 2.8 | 1.5 | 3.7 | 1.5 | 0.6 | 40.0 |
| | D-1 | 0.60 | 0.20 | 0.16 | 0.20 | 0.16 | 0.12 | 1.2 |
| | E-1 | | | 67 | | 67 | | |
| | F-1 | | | | 0.1 | 0.1 | | |
| | G-1 | 0.40 | 0.13 | 0.11 | 0.13 | 0.11 | 0.08 | 0.80 |
| H/Vi | | 1.0 | 1.0 | 1.0 | 1.0 | 1.0 | 1.6 | 0.9 |
| Physical properties of composition | Viscosity (Pa·s) | 5 | 3 | 3 | 7 | 3 | 5 | - |
| Physical properties of cured product | Hardness (Type A) | 54 | 22 | 14 | 37 | 12 | 3 | - |
| | Tensile strength (MPa) | 1.4 | 2.2 | 1.4 | 4.5 | 1.3 | 0.1 | - |
| | Elongation at break (%) | 40 | 150 | 350 | 280 | 330 | 200 | - |
| | Bonding force (MPa) | 0.110 | 0.010 | 0.040 | 0.190 | 0.050 | <0.001 | - |
| | Half-life @6kV | >10 min | >10 min | >10 min | 1 sec | 1 sec | >10 min | - |

As seen from Tables 1 and 2, the addition curable silicone PSA compositions prepared in Examples 1 to 11 have an adequate viscosity. The cured products thereof have excellent adhesiveness and tensile strength and are thus useful as temporary adhesive for transferring miniature objects such as chips. The compositions of Examples 10 and 11 further having component (F-1) added thereto have excellent antistatic properties.

In contrast, the composition of Comparative Example 1 not containing component (B) is inferior in adhesiveness and tensile strength. The composition of Comparative Example 2 containing an excess of component (B-1) outside the range is solid and difficult to handle.

### REFERENCE SIGNS LIST

- 100, 101: microstructure transfer stamp
- 200,201: substrate
- 300, 310: cured product layer
- 311: protrusion
- 312: base layer
- 401: mold

## Claims

1. An addition curable silicone pressure-sensitive adhesive composition comprising:
(A) 100 parts by weight of an organopolysiloxane containing at least two silicon-bonded alkenyl groups per molecule and having a viscosity at 25°C of 0.01 to 1,000 Pa·s,
(B) 5 to 500 parts by weight of an organopolysiloxane resin having an alkenyl group,
(C) an organohydrogenpolysiloxane having at least two silicon-bonded hydrogen atoms per molecule, in such an amount as to give 0.1 to 5.0 moles of silicon-bonded hydrogen in component (C) per mole of total silicon-bonded alkenyl groups in the composition, and
(D) a platinum group metal based catalyst,
the composition being free of a non-crosslinkable organopolysiloxane resin.

2. The composition of claim 1, further comprising (E) an organic solvent in an amount of 1 to 10,000 parts by weight per 100 parts by weight of component (A).

3. The composition of claim 1 or 2, further comprising (F) an antistatic agent in an amount of 0.001 to 10 parts by weight per 100 parts by weight of component (A).

4. The composition of any one of claims 1 to 3, further comprising (G) a reaction inhibitor in an amount of 0.01 to 5.0 parts by weight per 100 parts by weight of component (A).

5. A silicone cured product obtained by curing the addition curable silicone pressure-sensitive adhesive composition of any one of claims 1 to 4.

6. The cured product of claim 5, having a bonding force of at least 0.001 MPa.

7. The cured product of claim 5 or 6, having a tensile strength of at least 0.3 MPa.

8. A pressure-sensitive adhesive comprising the silicone cured product of any one of claims 5 to 7.

9. A pressure-sensitive adhesive sheet comprising the silicone cured product of any one of claims 5 to 7.

10. A microstructure transfer stamp comprising the silicone cured product of any one of claims 5 to 7.

11. The microstructure transfer stamp of claim 10, having at least one protrusion.

12. A microstructure transfer apparatus comprising the microstructure transfer stamp of claim 10 or 11.

13. A microstructure holding substrate comprising a pressure-sensitive adhesive layer of the silicone cured product of any one of claims 5 to 7.

14. A microstructure transfer apparatus comprising the microstructure holding substrate of claim 13.
